# EUROPEAN PATENT APPLICATION

(11) **EP 4 503 096 A1**
(43) Date of publication of application: **05.02.2025**
(21) Application number: 23774734.0
(22) Date of filing: 16.03.2023
(51) Int. Cl.: H01L 21/304, C08L 83/05, C08L 83/07, C08L 83/12, C09J 183/05, C09J 183/07, H01L 21/02

(54) **ADHESIVE CONTAINING POLYETHER-MODIFIED SILOXANE**

(30) Priority: 24.03.2022 JP 2022048118
(71) Applicant: Nissan Chemical Corporation, Tokyo 103-6119 (JP)
(72) Inventor: YANAI, Masaki, Toyama-shi, Toyama 939-2792 (JP); OKUNO, Takahisa, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2023/010292
(87) International publication number: WO 2023/182138

(57) **Abstract**

To provide an adhesive which is excellent in spin coatability to the circuit surface of a wafer and a support (support substrate), is excellent in heat resistance at the time of bonding the circuit surface of the wafer and the support via an adhesive layer and at the time of processing the back surface of the wafer, and allows for easy peel off of the wafer and the support after processing the wafer (for example, after polishing the back surface of the wafer), and a laminate having the adhesive.

Provided is an adhesive for peelably bonding between a support and a circuit surface of a wafer to allow for processing of a back surface of the wafer, the adhesive including a component (A) that cures through a hydrosilylation reaction and a component (B) containing a polyether-modified siloxane.

## Description

### Technical Field

The present invention relates to an adhesive for fixing a wafer to a support at the time of polishing the back surface of the wafer, a laminate obtained using the adhesive, and methods for producing and peeling off the laminate.

### Background Art

For a semiconductor wafer that has been conventionally integrated in a two-dimensional planar direction, a semiconductor integration technology is required in which a planar surface is further integrated (laminated) also in a three-dimensional direction for the purpose of further integration. This three-dimensional lamination is a technique of integrating layers while connecting them by a through silicon via (TSV). At the time of multi-layer integration, respective wafers to be integrated are thinned by polishing on the side opposite to the formed circuit surface (that is, the back surface), and the thinned semiconductor wafers are laminated.

A semiconductor wafer (also referred to herein simply as a wafer) before thinning is adhesively bonded to a support in order to be polished with a polishing apparatus. Adhesion performed at that time is called temporary adhesive bond because the semiconductor wafer needs to be easily peeled off after polishing. This temporary adhesive bond must allow for easy removal from the support. Otherwise, the thinned semiconductor wafer may be cut or deformed when a large force is applied for the removal. In order to prevent such a situation, the semiconductor wafer is easily removed. On the other hand, it is not also preferable that polishing stress at the time of polishing the back surface of the semiconductor wafer cause the semiconductor wafer to be detached or displaced. Therefore, the performance required for temporary adhesive bond is to withstand the stress at the time of polishing and to allow for easy removal after polishing.

For example, there is a demand for performance having a high stress (strong adhesive bond force) in the planar direction at the time of polishing and a low stress (weak adhesive bond force) in the longitudinal direction at the time of removal.

As such an adhesively bonding process, a method in which an adhesive layer and a separation layer are provided, the separation layer is formed by plasma polymerization of dimethylsiloxane, and mechanical separation is performed after polishing (see Patent Literature 1 and Patent Literature 2); and
a method including adhesively bonding a support substrate and a semiconductor wafer with an adhesive composition, polishing the back surface of the semiconductor wafer, and then removing the adhesive with an etching solution (see Patent Literature 3); and
as an adhesive layer for adhesively bonding a support and a semiconductor wafer, a processed wafer including a combination of a polymerized layer obtained by polymerizing an alkenyl group-containing organopolysiloxane and a hydrosilyl group-containing organopolysiloxane with a platinum catalyst, and a polymerized layer made of a thermosetting polysiloxane (see Patent Literature 4, Patent Literature 5, Patent Literature 6, and Patent Literature 7)
are disclosed.

With the recent further development in the semiconductor field, new development regarding adhesive components is always required.

### Citation List

### Patent Literature

Patent Literature 1: JP 2012-510715 W
Patent Literature 2: JP 2012-513684 W
Patent Literature 3: JP 2008-532313 W
Patent Literature 4: JP 2013-179135 A
Patent Literature 5: JP 2013-232459 A
Patent Literature 6: JP 2006-508540 A
Patent Literature 7: JP 2009-528688 A

### Summary of Invention

### Technical Problem

An object of the present invention is to provide an adhesive which is excellent in spin coatability to the circuit surface of a wafer and a support (support substrate), is excellent in heat resistance at the time of bonding the circuit surface of the wafer and the support via an adhesive layer and at the time of processing the back surface of the wafer, and allows for easy peel off of the wafer and the support after processing the wafer (for example, after polishing the back surface of the wafer), and a laminate having the adhesive.

Another object of the present invention is to provide methods for producing and peeling off the laminate.

### Solution to Problem

As a result of intensive studies to solve the above problems, the present inventors have found that the above problems can be solved, and have completed the present invention having the following gist.

That is, the present invention includes the following.
[1] An adhesive for peelably bonding between a support and a circuit surface of a wafer to allow for processing of a back surface of the wafer, the adhesive including a component (A) that cures through a hydrosilylation reaction and a component (B) containing a polyether-modified siloxane.
[2] The adhesive according to [1], wherein
   the component (A) contains a polysiloxane (A1) and a platinum group metal-based catalyst (A2), in which
   the polysiloxane (A1) includes a polyorganosiloxane (a1) and a polyorganosiloxane (a2),
   the polyorganosiloxane (a1) includes a polysiloxane containing at least one unit selected from the group consisting of a siloxane unit represented by SiO₂ (Q unit), a siloxane unit represented by R¹R²R³SiO_{1/2} (M unit), a siloxane unit represented by R⁴R⁵SiO_{2/2} (D unit), and a siloxane unit represented by R⁶SiO_{3/2} (T unit) (the R¹ to R⁶ each independently represent an alkyl group having 1 to 10 carbon atoms or an alkenyl group having 2 to 10 carbon atoms, and are bonded to a silicon atom by a Si-C bond, and the polysiloxane contains an alkyl group having 1 to 10 carbon atoms and an alkenyl group having 2 to 10 carbon atoms), and
   the polyorganosiloxane (a2) includes a polysiloxane containing at least one unit selected from the group consisting of a siloxane unit represented by SiO₂ (Q unit), a siloxane unit represented by R¹R²R³SiO_{1/2} (M unit), a siloxane unit represented by R⁴R⁵SiO_{2/2} (D unit), and a siloxane unit represented by R⁶SiO_{3/2} (T unit) (the R¹ to R⁶ each independently represent an alkyl group having 1 to 10 carbon atoms or a hydrogen atom, and are bonded to a silicon atom by a Si-C bond or an Si-H bond, and the polysiloxane contains an alkyl group having 1 to 10 carbon atoms and an Si-H group).
[3] The adhesive according to [1] or [2], wherein
   the component (B) contains
   a polyether-modified siloxane having a group represented by the following formula (B-1) or a polyether-modified siloxane represented by the following formula (B-2) . 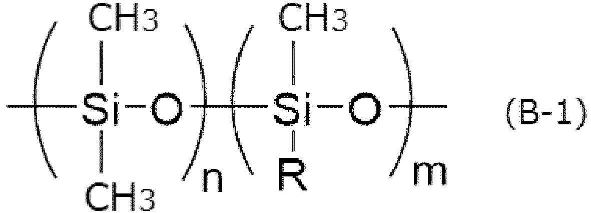 (in the formula (B-1), R represents a group containing a poly(oxyethylene) and/or poly(oxypropylene) group, and n and m each represent an integer.) 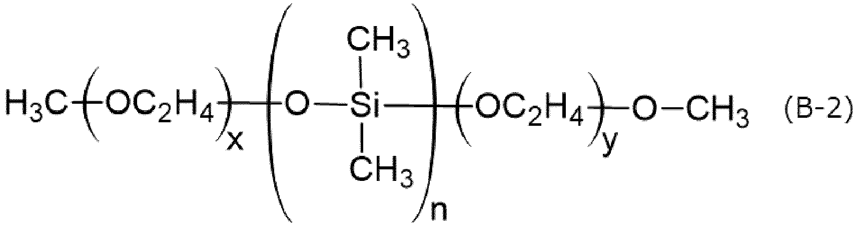 (in the formula (B-2), n, x and y each represent an integer.)
[4] The adhesive according to [3], wherein in the formula (B-1), the group represented by R is a poly(oxyethylene) group, a poly(oxypropylene) group, or a group represented by the following formula (B-1-1). 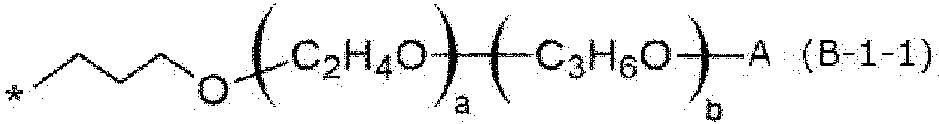 (in the formula (B-1-1), A represents H or CH₃, * represents a bond, a and b each represent an integer of 0 or more, and a + b is an integer of 1 or more.)
[5] The adhesive according to any one of [1] to [4], wherein the processing is back surface polishing of the wafer.
[6] A laminate having:
   a first body;
   a second body; and
   an adhesive layer provided between the first body and the second body, wherein
   the adhesive layer is formed of the adhesive according to any one of [1] to [5].
[7] A method for producing a laminate, including applying the adhesive according to any one of [1] to [5] onto a first body to form a coating film, disposing a second body on a side of the coating film opposite to a side of the first body, and performing heating in a bonding state in which the first body and the coating film are in contact with each other and the coating film and the second body are in contact with each other, thereby forming a laminate in which the first body and the second body are bonded via an adhesive layer.
[8] The method for producing a laminate according to [7], wherein the first body is a support, the second body is a wafer, and a circuit surface of the wafer faces the first body.
[9] The method for producing a laminate according to [7], wherein the first body is a wafer, the second body is a support, and a circuit surface of the wafer faces the second body.
[10] A method for peeling off a laminate, including applying the adhesive according to any one of [1] to [4] onto a first body to form a coating film, disposing a second body on a side of the coating film opposite to a side of the first body, and performing heating in a bonding state in which the first body and the coating film are in contact with each other and the coating film and the second body are in contact with each other, thereby forming a laminate in which the first body and the second body are bonded to each other via an adhesive layer, processing the formed laminate, and then peeling off the first body and the second body.
[11] A method for peeling off a laminate, including applying the adhesive according to [5] onto a first body to form a coating film, disposing a second body on a side of the coating film opposite to a side of the first body, and performing heating in a bonding state in which the first body and the coating film are in contact with each other and the coating film and the second body are in contact with each other, thereby forming a laminate in which the first body and the second body are bonded to each other via an adhesive layer, processing the formed laminate, and then peeling off the first body and the second body.
[12] The method for peeling off a laminate according to [10], wherein the first body is a support, the second body is a wafer, and a circuit surface of the wafer faces the first body.
[13] The method for peeling off a laminate according to [11], wherein the first body is a support, the second body is a wafer, and a circuit surface of the wafer faces the first body.
[14] The method for peeling off a laminate according to [10], wherein the first body is a wafer, the second body is a support, and a circuit surface of the wafer faces the second body.
[15] The method for peeling off a laminate according to [11], wherein the first body is a wafer, the second body is a support, and a circuit surface of the wafer faces the second body.
[16] The method for peeling off a laminate according to any one of [10], [12] and [14], wherein the processing is back surface polishing of the wafer.

### Advantageous Effects of Invention

According to the present invention, an adhesive can be provided which is excellent in spin coatability to the circuit surface of a wafer and a support (support substrate), is excellent in heat resistance at the time of bonding the circuit surface of the wafer and the support via an adhesive layer and at the time of processing the back surface of the wafer, and allows for easy peel off of the wafer and the support after processing the wafer (for example, after polishing the back surface of the wafer), and a laminate having the adhesive.

Furthermore, according to the present invention, methods for producing and peeling off the laminate can be provided.

### Description of Embodiments

### (Adhesive)

An adhesive of the present invention is for peelably bonding between a support and the circuit surface of a wafer to allow for processing of the back surface of the wafer, and can be suitably used for forming an adhesive layer for temporary adhesive bond to allow for processing of a semiconductor wafer.

The adhesive of the present invention contains a component (A) that cures through a hydrosilylation reaction and a component (B) including a polyether-modified siloxane.

When a specific polysiloxane (corresponding to the component (B)) is contained in the adhesive, the adhesive of the present invention is so excellent in heat resistance at the time of bonding the circuit surface of a wafer and a support via an adhesive layer or at the time of high temperature processing, as shown in the following Examples, that the wafer and the support can be easily peeled off from each other.

In the present invention, the support and the wafer are temporarily adhesively bonded by the adhesive, and the back surface of the wafer on the side opposite to the circuit surface thereof is processed by polishing or the like, whereby the thickness of the wafer can be thinned.

The temporary adhesive bond can provide adhesive bond when the back surface of the wafer is polished, and separation of the thinned wafer from the support after the back surface of the wafer is polished.

Here, the term "peelably" means that the peeling strength is so lower than that of other peeled portions that peeling is easy.

In the present invention, the adhesive layer (temporary adhesive layer) is formed of the adhesive of the present invention. The adhesive contains the component (A) and the component (B), and may further contain another additive.

### <Component (A) cured through hydrosilylation reaction>

The component (A) contains a polysiloxane (A1) and a platinum group metal-based catalyst (A2), in which
the polysiloxane (A1) includes a polyorganosiloxane (a1) and a polyorganosiloxane (a2),
the polyorganosiloxane (a1) includes a polysiloxane containing at least one unit selected from the group consisting of a siloxane unit represented by SiO₂ (Q unit), a siloxane unit represented by R¹R²R³SiO_{1/2} (M unit), a siloxane unit represented by R⁴R⁵SiO_{2/2} (D unit), and a siloxane unit represented by R⁶SiO_{3/2} (T unit) (R¹ to R⁶ each independently represent an alkyl group having 1 to 10 carbon atoms or an alkenyl group having 2 to 10 carbon atoms, and are bonded to a silicon atom by a Si-C bond, and the polysiloxane contains an alkyl group having 1 to 10 carbon atoms and an alkenyl group having 2 to 10 carbon atoms), and
the polyorganosiloxane (a2) includes a polysiloxane containing at least one unit selected from the group consisting of a siloxane unit represented by SiO₂ (Q unit), a siloxane unit represented by R¹R²R³SiO_{1/2} (M unit), a siloxane unit represented by R⁴R⁵SiO_{2/2} (D unit), and a siloxane unit represented by R⁶SiO_{3/2} (T unit) (R¹ to R⁶ each independently represent an alkyl group having 1 to 10 carbon atoms or a hydrogen atom, and are bonded to a silicon atom by a Si-C bond or an Si-H bond, and the polysiloxane contains an alkyl group having 1 to 10 carbon atoms and an Si-H group).

The polysiloxane (A1) contains a polyorganosiloxane (a1) and a polyorganosiloxane (a2). The polyorganosiloxane (a1) includes an alkyl group having 1 to 10 carbon atoms and an alkenyl group having 2 to 10 carbon atoms, and the polyorganosiloxane (a2) includes an alkyl group having 1 to 10 carbon atoms and a hydrogen atom. An alkenyl group and an Si-H group form a crosslinked structure through a hydrosilylation reaction by a platinum group metal-based catalyst (A2) to cure.

The polyorganosiloxane (a1) is selectively formed of a Q unit, an M unit, a D unit and a T unit, and can be formed of, for example, a combination of (a Q unit and an M unit) and (a D unit and an M unit), a combination of (a T unit and an M unit) and (a D unit and an M unit), a combination of (a Q unit, a T unit and an M unit) and (a T unit and an M unit), a combination of (a T unit and an M unit), and a combination of (a Q unit and an M unit).

The polyorganosiloxane (a2) is selectively formed of a Q unit, an M unit, a D unit and a T unit, and can be formed of, for example, a combination of (an M unit and a D unit), a combination of (a Q unit and an M unit), and a combination of (a Q unit, a T unit and an M unit).

The alkenyl group having 2 to 10 carbon atoms includes, for example, an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, a 2-methyl-2-butenyl group, a 2-methyl-3-butenyl group, a 3-methyl-1-butenyl group, a 3-methyl-2-butenyl group, a 3-methyl-3-butenyl group, a 1,1-dimethyl-2-propenyl group, a 1-i-propylethenyl group, a 1,2-dimethyl-1-propenyl group, a 1,2-dimethyl-2-propenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dipentenylmethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, and a 1-i-propyl-2-propenyl group. In particular, an ethenyl group, that is, a vinyl group, and a 2-propenyl group, that is, an allyl group may be preferably used.

The alkyl group having 1 to 10 carbon atoms includes, for example, a methyl group, an ethyl group, an n-propyl group, an i-propyl group, an n-butyl group, an i-butyl group, an s-butyl group, a t-butyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group. In particular, a methyl group may be preferably used.

The polyorganosiloxane (a1) may be composed of an alkyl group having 1 to 10 carbon atoms and an alkenyl group having 2 to 10 carbon atoms, the alkyl group having 1 to 10 carbon atoms may be a methyl group, the alkenyl group having 2 to 10 carbon atoms may be an ethenyl group, that is, a vinyl group, and the content of the alkenyl group may be 0.1 mol% to 50.0 mol%, preferably 0.5 mol% to 30.0 mol% based on the total amount of substituents represented by R¹ to R⁶, and the remaining R¹ to R⁶ may be the alkyl group.

The polyorganosiloxane (a2) is composed of an alkyl group having 1 to 10 carbon atoms and a hydrogen atom, the alkyl group having 1 to 10 carbon atoms is a methyl group, and the hydrogen atom forms an Si-H structure. The content of the hydrogen atom, that is, the Si-H group may be 0.1 mol% to 50.0 mol%, preferably 10.0 mol% to 40.0 mol% based on the total amount of substituents represented by R¹ to R⁶, and the remaining R¹ to R⁶ may be the alkyl group.

The polyorganosiloxane (a1) and the polyorganosiloxane (a2) may contain hydrogen atoms represented in the alkenyl group and the Si-H group in a molar ratio in the range of 2.0 : 1.0, preferably 1.5 . 1.0.

The polyorganosiloxane (a1) and the polyorganosiloxane (a2) may each have a weight average molecular weight in the range of 500 to 1,000,000 or 5000 to 50,000.

The component (A) contains a platinum group metal-based catalyst (A2). The platinum-based metal catalyst is a catalyst for promoting a hydrosilylation addition reaction between an alkenyl group and an Si-H group, and platinum-based catalysts are used such as platinum black, platinum(II) chloride, chloroplatinic acid, a reaction product between chloroplatinic acid and a monohydric alcohol, a complex of chloroplatinic acid and olefins, and platinum bisacetoacetate. Examples of the complex of platinum and olefins include a complex of divinyltetramethyldisiloxane and platinum. The amount of the platinum catalyst added may be in the range of 1.0 to 50.0 ppm with respect to the total amount of the polyorganosiloxane (a1) and the polyorganosiloxane (a2).

As for the component (A), an alkynyl alcohol may be further added as an inhibitor (A3) for inhibiting the progress of the hydrosilylation reaction. Examples of the inhibitor include 1-ethynyl-1-cyclohexanol and 1,1-diphenyl-2-propyn-1-ol. The amount of the inhibitors added may be in a range of 1,000.0 to 10,000.0 ppm with respect to the polyorganosiloxane (a1) and the polyorganosiloxane (a2) .

### <Component (B) containing polyether-modified siloxane>

As the polyether-modified siloxane for use in the component (B) of the present invention, a polyether-modified siloxane having a group represented by the following formula (B-1) or a polyether-modified siloxane represented by the following formula (B-2) may be used.

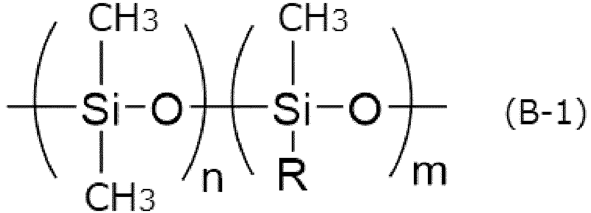

In the formula (B-1), R represents a group containing a poly(oxyethylene) and/or poly(oxypropylene) group. n and m each represent an integer.

In the formula (B-1), the arrangement of (OSi(CH₃)₂) and (OSiRCH₃) may be block or random.

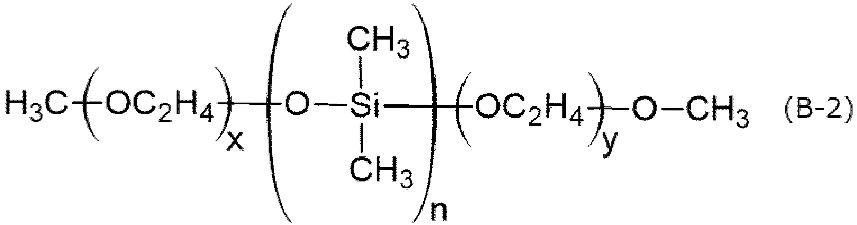

In the formula (B-2), n, x and y each represent an integer.

In the formula (B-1), the group represented by R is preferably a poly(oxyethylene) group, a poly(oxypropylene) group, or a group represented by the following formula (B-1-1) .

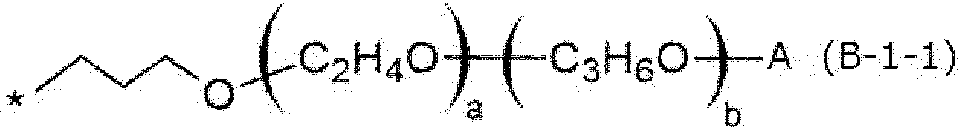

In the formula (B-1-1), A represents H or CH₃. * represents a bond. a and b each represent an integer of 0 or more, and a + b is an integer of 1 or more.

In the formula (B-1-1), the structure represented by (C₃H₆O) may be linear or branched, and the arrangement of (C₂H₄O) and (C₃H₆O) may be block or random.

In the formula (B-1), the average oxyethylene chain length per group represented by the polyether substitution site R, that is, a in the formula (B-1-1) is preferably 5 to 100, and the average oxypropylene chain length, that is, b in the formula (B-1-1) is preferably 2 to 120.

In the formula (B-2), the average oxyethylene chain length with respect to a methyl group, that is, x + y in the formula (B-2) is preferably 10 to 30.

As the component (B) containing a polyether-modified siloxane, a commercially available product may also be used, and examples thereof include "KP124" manufactured by Shin-Etsu Chemical Co., Ltd., and "L066, L060, L053, DMC6031, DMC6038" manufactured by Wacker Chemie AG.

For the adhesiveness, the component (A) and the component (B) in the adhesive may be contained in an optional ratio. In order to further improve the peelability, the component (B) is desirably contained in an amount of 0.3 or more in terms of mass%, and in order to maintain the mechanical properties of the adhesive, the component (B) is desirably 2 or less in terms of mass%. The ratio of the component (A) and the component (B) in the adhesive may be 100 : 0.3 to 100 : 2 in mass%.

### <Another component>

The adhesive of the present invention may contain a solvent for the purpose of adjusting the viscosity or the like, or for favorably dissolving the membrane constituent.

Specific examples of the solvent include, but are not limited to, aliphatic hydrocarbons, aromatic hydrocarbons, and ketones.

More specifically, as the solvent, hexane, heptane, octanonane, decane, undecane, dodecane, isododecane, menthane, limonene, toluene, xylene, methicylene, cumene, MIBK (methyl isobutyl ketone), butyl acetate, diisobutyl ketone, 2-octanone, 2-nonanone, 5-nonanone, and the like may be used.

Such solvents may be used alone or in combination of two or more kinds thereof.

### (Laminate)

The laminate of the present invention includes:
a first body;
a second body; and
an adhesive layer provided between the first body and the second body.

The adhesive layer is a layer formed of the adhesive of the present invention described above.

The laminate is used when the first body and the second body are peeled off.

The first body may be a support or a wafer, and the second body may be a support or a wafer, provided that when the first body is a support, the second body is a wafer, and when the first body is a wafer, the second body is a support.

Examples of the wafer include a silicon wafer having a diameter of about 300 mm and a thickness of about 770 um.

Examples of the support (carrier) may include a glass wafer or a silicon wafer having a diameter of about 300 mm and a thickness of about 700 µm.

The thickness of the adhesive layer is not particularly limited, but is usually 5 to 500 um, preferably 10 um or more, more preferably 20 um or more, still more preferably 30 um or more from the viewpoint of maintaining the film strength, and is preferably 200 um or less, more preferably 150 um or less, still more preferably 120 um or less, still more preferably 70 um or less from the viewpoint of avoiding nonuniformity caused by a thick film.

Accordingly, the film thickness of the adhesive layer is, for example, preferably 5 to 500 µm, more preferably 10 to 200 µm, still more preferably 20 to 150 µm, still more preferably 30 to 120 µm, particularly preferably 30 to 70 µm.

### (Method for producing laminate)

In the present invention, a method for producing a laminate is mentioned, including applying the adhesive onto a first body to form a coating film, disposing a second body on a side of the coating film opposite to the side of the first body, and performing heating in a bonding state in which the first body and the coating film are in contact with each other and the coating film and the second body are in contact with each other, thereby forming a laminate in which the first body and the second body are bonded to each other via an adhesive layer.

The adhesive is cured by heating.

In the present description, the coating film refers to a coating layer made of the adhesive.

A method for producing a laminate is mentioned in which the first body is a support, the second body is a wafer, and the circuit surface of the wafer faces the first body.

Furthermore, a method for producing a laminate is mentioned in which the first body is a wafer, the second body is a support, and the circuit surface of the wafer faces the second body.

In the formation of the adhesive layer, an adhesive is attached onto the first body by, for example, a spin coater to form the coating film. A coating film is bonded between the first body and the second body, more specifically, between the support and the circuit surface of the wafer so as to be interposed therebetween, and the adhesive is cured by heating to form the adhesive layer. In this way, a laminate can be formed in which the first body and the second body are bonded to each other via the adhesive layer.

A more specific description is made.

The adhesive is attached onto the support by, for example, a spin coater to form the coating film. Bonding is performed such that the support and the coating film are in contact with each other and the coating film and the circuit surface of the wafer are in contact with each other so as to interpose the coating film between the support and the circuit surface of the wafer, and for example, the adhesive is cured by heating at a temperature of 120 to 260°C to form the adhesive layer. In this way, a laminate can be formed in which the support and the wafer are bonded to each other via the adhesive layer.

Alternatively, the adhesive is attached to the circuit surface with the back surface of the wafer facing downward by, for example, a spin coater to form the coating film. Bonding is performed such that the support and the coating film are in contact with each other and the coating film and the circuit surface of the wafer are in contact with each other so as to interpose the coating film between the support and the circuit surface of the wafer, and for example, the adhesive is cured by heating at a temperature of 120 to 260°C to form the adhesive layer. In this way, a laminate can be formed in which the support and the wafer are bonded to each other via the adhesive layer.

### < Bonding step>

When bonding is performed such that the support and the coating film are in contact with each other and the coating film and the circuit surface of the wafer are in contact with each other, bonding is preferably performed under reduced pressure (for example, under a reduced pressure of 10 Pa to 10,000 Pa) so that the support and the wafer are sufficiently bonded via the coating film.

In addition, heating may be performed at the time of bonding, and for example, bonding may be performed by heating (for example, 30°C to 100°C) under reduced pressure.

### <Heating step>

After bonding is performed such that the support and the coating film are in contact with each other and the coating film and the circuit surface of the wafer are in contact with each other, heat treatment is performed.

The heating temperature and time may be any temperature and time at which the coating film (the coating layer of the adhesive) is converted into the adhesive layer, and are, for example, as follows.

The heating temperature may be about 120°C at which the adhesive starts to cure, and 260°C or higher, but is preferably 260°C or lower from the viewpoint of heat resistance of the circuit surface (device surface) of the wafer, and may be, for example, about 150°C to 220°C, or about 190°C to 200°C.

The heating time is desirably 1 minute or more from the viewpoint of bonding the wafer by curing, and more preferably 5 minutes or more from the viewpoint of further stabilizing the physical properties of the adhesive. For example, the heating time may be 1 to 180 minutes or 5 to 120 minutes.

As the heater, a hot plate, an oven, or the like may be used.

### (Method for peeling off laminate)

In the present invention, a method for peeling off a laminate is mentioned, including applying the adhesive onto a first body to form a coating film, disposing a second body on a side of the coating film opposite to the side of the first body, and performing heating in a bonding state in which the first body and the coating film are in contact with each other and the coating film and the second body are in contact with each other, thereby forming a laminate in which the first body and the second body are bonded to each other via an adhesive layer, processing the formed laminate, and then peeling off the first body and the second body.

The peeling occurs, for example, at an interface between the first body and the adhesive layer or an interface between the second body and the adhesive layer.

A method for peeling off a laminate is mentioned in which the first body is a support, the second body is a wafer, and the circuit surface of the wafer faces the first body.

Furthermore, a method for peeling off a laminate is mentioned in which the first body is a wafer, the second body is a support, and the circuit surface of the wafer faces the second body.

### <Processing step>

The processing on the side opposite to the circuit surface of the wafer includes thinning of the wafer by polishing. Thereafter, a through silicon via (TSV) or the like is formed.

After the processing, the thinned wafer is peeled off from the support to form a laminate of wafers for three-dimensional packaging. Before and after that, a wafer-back electrode and the like are also formed. Heat of 250 to 350°C is added for thinning of a wafer and a TSV process in an adhesively bonded state to a support, and a laminate obtained using the adhesive of the present invention has heat resistance to the added heat.

For example, a wafer having a diameter of about 300 mm and a thickness of about 770 um can be thinned to a thickness of about 80 um to 4 um by polishing the back surface opposite to the circuit surface.

### <Peeling step>

After the back surface is processed (polished), the support and the wafer are peeled off.

Examples of the peeling method include solvent peeling, laser peeling, mechanical peeling with equipment having a sharp part, and peeling between a support and a wafer.

When the adhesive remains (resin remains) on the surface of the wafer, the resin may be removed by washing with a solvent (dissolution, lift-off), tape peeling, or the like.

In the present invention, the first body and the second body are bonded to each other via an adhesive layer to form a laminate by the above-described method. Thereafter, the laminate is processed (for example, the back surface of the wafer is polished), and then the first body and the second body are peeled off by the above-described method. In this way, according to the present invention, the polished wafer (that is, the thinned wafer) after processing can be easily peeled off from the support.

### Examples

Hereinafter, a more specific description is made of the present invention with reference to Examples, but the present invention is not limited to the following Examples. The apparatus used is as follows.

### [Apparatus]

(1) Mix rotor: Mix rotor VMR-5R manufactured by AS ONE Corporation
(2) Stirrer: Rotation and revolution mixer ARE-500 manufactured by THINKY Corporation
(3) Vacuum bonding apparatus: XBS300 manufactured by SUSS MicroTec SE
(4) Manual peeling apparatus: manual debonder manufactured by SUSS MicroTec SE
(5) Ultrasonic microscope: D9600Z/DC-SAM manufactured by SONOSCAN
(6) Inert gas oven: INL-60NI manufactured by Koyo Thermo Systems Co., Ltd.

### [1] Preparation of adhesive composition

### [Preparation Example 1]

In a 50 mL screw tube, 0.33 g of 1,1-diphenyl-2-propyn-1-ol (manufactured by Tokyo Chemical Industry Co., Ltd.) and 0.33 g of 1-ethynyl-1-cyclohexanol (manufactured by Wacker Chemie AG) were added, followed by stirring with a mix rotor for 10 minutes to yield a mixture (I). In a 300 mL stirring vessel dedicated to a rotation and revolution mixer, 0.33 g of the mixture (I), 16.2 g of a vinyl group-containing MQ resin (manufactured by Wacker Chemie AG), 12.2 g of a vinyl group-containing linear polydimethylsiloxane having a viscosity of 200 mPa·s (manufactured by Wacker Chemie AG), and 19.5 g of an SiH group-containing linear polydimethylsiloxane having a viscosity of 100 mPa·s (manufactured by Wacker Chemie AG) were added, followed by stirring with a stirrer for 5 minutes to yield a mixture (II). In a 300 mL stirring vessel dedicated to a rotation and revolution mixer, 181.5 g of a p-menthane solution (concentration: 81.7 mass%) of a vinyl group-containing MQ resin (manufactured by Wacker Chemie AG) and 0.10 g of a platinum catalyst (manufactured by Wacker Chemie AG) were added, followed by stirring with a stirrer for 5 minutes to yield a mixture (III). To the mixture (II), 121.1 g of the mixture (III) was added, followed by stirring with a stirrer for 5 minutes to yield a mixture (IV). To the mixture (IV), 1.24 g of polyether-modified silicone KP124 (manufactured by Shin-Etsu Chemical Co., Ltd.) was added such that a mixing ratio of the component (B) to the component (A) (component (A) : component (B)) was approximately 100 parts by mass : 1 part by mass, followed by stirring with a stirrer for 5 minutes to yield an adhesive (1).

### [Preparation Example 2]

An adhesive (2) was obtained in the same manner as in Preparation Example 1 except that 3.15 g of polyether-modified silicone KP124 (manufactured by Shin-Etsu Chemical Co., Ltd.) was added to the mixture (IV) such that the mixing ratio of the component (B) to the component (A) was 100 parts by mass : 2 parts by mass in Preparation Example 1.

### [Preparation Example 3]

An adhesive (3) was obtained in the same manner as in Preparation Example 1 except that 0.79 g of polyether-modified silicone KP124 (manufactured by Shin-Etsu Chemical Co., Ltd.) was added to the mixture (IV) such that the mixing ratio of the component (B) to the component (A) was 100 parts by mass : 0.5 parts by mass in Preparation Example 1.

### [Preparation Example 4]

An adhesive (4) was obtained in the same manner as in Preparation Example 1 except that 0.47 g of polyether-modified silicone KP124 (manufactured by Shin-Etsu Chemical Co., Ltd.) was added to the mixture (IV) such that the mixing ratio of the component (B) to the component (A) was 100 parts by mass : 0.3 parts by mass in Preparation Example 1.

### [Preparation Example 5]

An adhesive (5) was obtained in the same manner as in Preparation Example 1 except that 1.24 g of polyether-modified silicone L060 (manufactured by Wacker Chemie AG) was added to the mixture (IV) such that the mixing ratio of the component (B) to the component (A) was 100 parts by mass : 1 part by mass in Preparation Example 1.

### [Preparation Example 6]

An adhesive (6) was obtained in the same manner as in Preparation Example 1 except that 0.79 g of polyether-modified silicone L060 (manufactured by Wacker Chemie AG) was added to the mixture (IV) such that the mixing ratio of the component (B) to the component (A) was 100 parts by mass : 0.5 parts by mass in Preparation Example 1.

### [Preparation Example 7]

An adhesive (7) was obtained in the same manner as in Preparation Example 1 except that 0.47 g of polyether-modified silicone L060 (manufactured by Wacker Chemie AG) was added to the mixture (IV) such that the mixing ratio of the component (B) to the component (A) was 100 parts by mass : 0.3 parts by mass in Preparation Example 1.

### [Preparation Example 8]

An adhesive (8) was obtained in the same manner as in Preparation Example 1 except that 1.24 g of polyether-modified silicone L053 (manufactured by Wacker Chemie AG) was added to the mixture (IV) such that the mixing ratio of the component (B) to the component (A) was 100 parts by mass : 1 part by mass in Preparation Example 1.

### [Preparation Example 9]

An adhesive (9) was obtained in the same manner as in Preparation Example 1 except that 1.24 g of polyether-modified silicone DMC6031 (manufactured by Wacker Chemie AG) was added to the mixture (IV) such that the mixing ratio of the component (B) to the component (A) was 100 parts by mass : 1 part by mass in Preparation Example 1.

### [Preparation Example 10]

An adhesive (10) was obtained in the same manner as in Preparation Example 1 except that 1.24 g of polyether-modified silicone DMC6038 (manufactured by Wacker Chemie AG) was added to the mixture (IV) such that the mixing ratio of the component (B) to the component (A) was 100 parts by mass : 1 part by mass in Preparation Example 1.

### [Comparative Preparation Example 1]

In a 50 mL screw tube, 0.33 g of 1,1-diphenyl-2-propyn-1-ol (manufactured by Tokyo Chemical Industry Co., Ltd.) and 0.33 g of 1-ethynyl-1-cyclohexanol (manufactured by Wacker Chemie AG) were added, followed by stirring with a mix rotor for 10 minutes to yield a mixture (I). In a 300 mL stirring vessel dedicated to a rotation and revolution mixer, 0.33 g of the mixture (I), 16.2 g of a vinyl group-containing MQ resin (manufactured by Wacker Chemie AG), 12.2 g of a vinyl group-containing linear polydimethylsiloxane having a viscosity of 200 mPa·s (manufactured by Wacker Chemie AG), and 19.5 g of an SiH group-containing linear polydimethylsiloxane having a viscosity of 100 mPa·s (manufactured by Wacker Chemie AG) were added, followed by stirring with a stirrer for 5 minutes to yield a mixture (II). In a 300 mL stirring vessel dedicated to a rotation and revolution mixer, 181.5 g of a p-menthane solution (concentration: 81.7 mass%) of a vinyl group-containing MQ resin (manufactured by Wacker Chemie AG) and 0.10 g of a platinum catalyst (manufactured by Wacker Chemie AG) were added, followed by stirring with a stirrer for 5 minutes to yield a mixture (III). To the mixture (II), 121.1 g of the mixture (III) was added, followed by stirring with a stirrer for 5 minutes to yield a mixture (IV). To the mixture (IV), 7.9 g of EMS-622 (manufactured by Gelest, Inc.) was added such that a mixing ratio of the epoxy-modified silicone to the component (A) (component (A) : epoxy-modified silicone) was approximately 100 parts by mass : 5 parts by mass, followed by stirring with a stirrer for 5 minutes to yield a comparative adhesive (1).

### [3] Production of laminate for evaluation

### [Production Example 1]

The adhesives (1) to (10) and the comparative adhesive (1) were each applied to a 300 mm silicon wafer (thickness: 775 um) as a device side wafer by spin coating to form an adhesive layer on the circuit surface of the wafer in a film thickness of about 60 µm, with the result that coating films (coating layers of the adhesive) (1) to (10) and a comparative coating film (1) were obtained, respectively (these coating films (1) to (10) and the comparative coating film (1) are also collectively referred to simply as "coating film" in Examples).

The wafer having this coating film and a 300 mm silicon wafer (thickness: 775 um) as a wafer (support) on the carrier side were bonded on each other in a vacuum bonding apparatus (Manual bonder manufactured by SUSS MicroTec SE) so as to interpose the coating film, thereby producing a laminate. Thereafter, the laminate was subjected to heat treatment at 130°C for 5 minutes and at 200°C for 5 minutes with the device-side wafer facing down over a hot plate, thereby producing a laminate in which the device-side wafer and the carrier-side wafer were bonded via the adhesive layer.

The respective laminates having coating films (1) to (10) were heated to yield respective laminates having adhesive layers (1) to (10). In addition, the laminate having the comparative coating film (1) was heated to yield a laminate having a comparative adhesive layer (1). Note that the laminates having the adhesive layers (1) to (10) and the laminate having the comparative adhesive layer (1) are also collectively referred to simply as a "laminate" in Examples.

Thereafter, the presence or absence of voids in the laminate obtained by the heat treatment was confirmed using an ultrasonic microscope (D9600Z/DC-SAM manufactured by

### SONOSCAN).

When no void was observed after the heat treatment, "o" was written as having good adhesiveness, and when voids were observed, "×" was written as having poor adhesiveness.

In addition, the force required for peeling off the laminate was measured with a peeling device (Manual debonder manufactured by SUSS MicroTec SE) in order to confirm peelability.

The force required for peeling was indicated by a numerical value as a good result for laminates in which peeling was successfully achieved, and "×" was written as defects for laminates in which peeling was not successfully achieved.

When confirming the peelability, the peeling interface was confirmed. When peeling occurred at the interface between the device-side wafer and the adhesive layer, and the peeling surface was successfully selected, "device" was written, when peeling occurred at the interface between the carrier-side wafer (support) and the adhesive layer, and the peeling surface was successfully selected, "carrier" was written, when the peeling interface was not successfully selected, "Δ" was written, when cohesive fracture occurred in the adhesive layer, "×" was written, and when peeling was not achieved, "-" was written. The results are shown in Table 1.

**[Table 1]**

| | Adhesiveness | Peelability | Peeling interface |
|---|---|---|---|
| Adhesive layer (1) | ○ | 15 N | Carrier |
| Adhesive layer (2) | ○ | 13 N | Carrier |
| Adhesive layer (3) | ○ | 18 N | Carrier |
| Adhesive layer (4) | ○ | 19 N | Carrier |
| Adhesive layer (5) | ○ | 18 N | Carrier |
| Adhesive layer (6) | ○ | 19 N | Carrier |
| Adhesive layer (7) | ○ | 20 N | Carrier |
| Adhesive layer (8) | ○ | 21 N | Carrier |
| Adhesive layer (9) | ○ | 15 N | Carrier |
| Adhesive layer (10) | ○ | 15 N | Carrier |
| Comparative adhesive layer (1) | ○ | 15 N | Device |

### [Production Example 2]

The adhesives (1) to (10) and the comparative adhesive (1) were each applied to a 300 mm silicon wafer (thickness: 775 um) as a carrier side wafer (support) with a film thickness of about 60 um by spin coating to form an adhesive layer on the circuit surface of the wafer, with the result that coating films (1) to (10) and a comparative coating film (1) were obtained, respectively.

The wafer having this coating film and a 300 mm silicon wafer (thickness: 775 um) as a wafer on the device side were bonded on each other in a vacuum bonding apparatus (Manual bonder manufactured by SUSS MicroTec SE) so as to interpose the coating film, thereby producing a laminate. Thereafter, the laminate was subjected to heat treatment at 130°C for 5 minutes and at 200°C for 5 minutes with the device-side wafer facing down over a hot plate, thereby producing a laminate in which the device-side wafer and the carrier-side wafer were bonded via the adhesive layer.

The respective laminates having coating films (1) to (10) were heated to yield respective laminates having adhesive layers (1) to (10). In addition, the laminate having the comparative coating film (1) was heated to yield a laminate having a comparative adhesive layer (1).

Thereafter, the presence or absence of voids in the laminate obtained by the heat treatment was confirmed using an ultrasonic microscope (D9600Z/DC-SAM manufactured by SONOSCAN).

When no void was observed after the heat treatment, "o" was written as having good adhesiveness, and when voids were observed, "×" was written as having poor adhesiveness.

In addition, the force required for peeling off the laminate was measured with a peeling device (Manual debonder manufactured by SUSS MicroTec SE) in order to confirm peelability.

The force required for peeling was indicated by a numerical value as a good result for laminates in which peeling was successfully achieved, and "×" was written as defects for laminates in which peeling was not successfully achieved.

When confirming the peelability, the peeling interface was confirmed. When peeling occurred at the interface between the device-side wafer and the adhesive layer, and the peeling surface was successfully selected, "device" was written, when peeling occurred at the interface between the carrier-side wafer (support) and the adhesive layer, and the peeling surface was successfully selected, "carrier" was written, when the peeling interface was not successfully selected, "Δ" was written, when cohesive fracture occurred in the adhesive layer, "×" was written, and when peeling was not achieved, "-" was written. The results are shown in Table 2.

**[Table 2]**

| | Adhesiveness | Peelability | Peeling interface |
|---|---|---|---|
| Adhesive layer (1) | ○ | 16 N | Device |
| Adhesive layer (2) | ○ | 13 N | Device |
| Adhesive layer (3) | ○ | 19 N | Device |
| Adhesive layer (4) | ○ | 19 N | Device |
| Adhesive layer (5) | ○ | 16 N | Device |
| Adhesive layer (6) | ○ | 19 N | Device |
| Adhesive layer (7) | ○ | 21 N | Device |
| Adhesive layer (8) | ○ | 14 N | Device |
| Adhesive layer (9) | ○ | 23 N | Device |
| Adhesive layer (10) | ○ | 16 N | Device |
| Comparative adhesive layer (1) | ○ | 18 N | Device |

From the results of Production Example 1 and Production Example 2, it has been confirmed that the adhesive of the present invention is peeled off at the interface between the wafer on the side opposite to the wafer side to which the adhesive has been applied and the adhesive layer. As a result, a user can control whether the peeling interface is generated between the wafer on the device side or the carrier side and the adhesive layer depending on whether the adhesive is first applied to the wafer on the device side or the carrier side. When the peeling interface generation can be controlled, the range of options of conditions such as a peeling condition and a cleaning condition after peeling can be expanded.

## Claims

1. An adhesive for peelably bonding between a support and a circuit surface of a wafer to allow for processing of a back surface of the wafer, the adhesive comprising a component (A) that cures through a hydrosilylation reaction and a component (B) containing a polyether-modified siloxane.

2. The adhesive according to claim 1, wherein
the component (A) contains a polysiloxane (A1) and a platinum group metal-based catalyst (A2), in which
the polysiloxane (A1) includes a polyorganosiloxane (a1) and a polyorganosiloxane (a2),
the polyorganosiloxane (a1) includes a polysiloxane containing at least one unit selected from the group consisting of a siloxane unit represented by SiO₂ (Q unit), a siloxane unit represented by R¹R²R³SiO_{1/2} (M unit), a siloxane unit represented by R⁴R⁵SiO_{2/2} (D unit), and a siloxane unit represented by R⁶SiO_{3/2} (T unit) (the R¹ to R⁶ each independently represent an alkyl group having 1 to 10 carbon atoms or an alkenyl group having 2 to 10 carbon atoms, and are bonded to a silicon atom by a Si-C bond, and the polysiloxane contains an alkyl group having 1 to 10 carbon atoms and an alkenyl group having 2 to 10 carbon atoms), and
the polyorganosiloxane (a2) includes a polysiloxane containing at least one unit selected from the group consisting of a siloxane unit represented by SiO₂ (Q unit), a siloxane unit represented by R¹R²R³SiO_{1/2} (M unit), a siloxane unit represented by R⁴R⁵SiO_{2/2} (D unit), and a siloxane unit represented by R⁶SiO_{3/2} (T unit) (the R¹ to R⁶ each independently represent an alkyl group having 1 to 10 carbon atoms or a hydrogen atom, and are bonded to a silicon atom by a Si-C bond or an Si-H bond, and the polysiloxane contains an alkyl group having 1 to 10 carbon atoms and an Si-H group).

3. The adhesive according to claim 1, wherein
the component (B) contains
a polyether-modified siloxane having a group represented by the following formula (B-1) or a polyether-modified siloxane represented by the following formula (B-2) 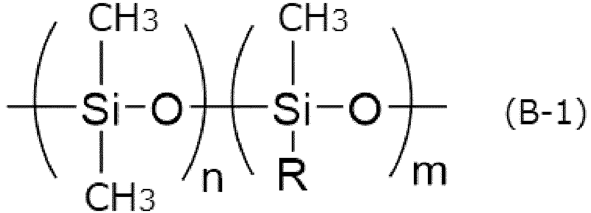
(in the formula (B-1), R represents a group containing a poly(oxyethylene) and/or poly(oxypropylene) group, and n and m each represent an integer) 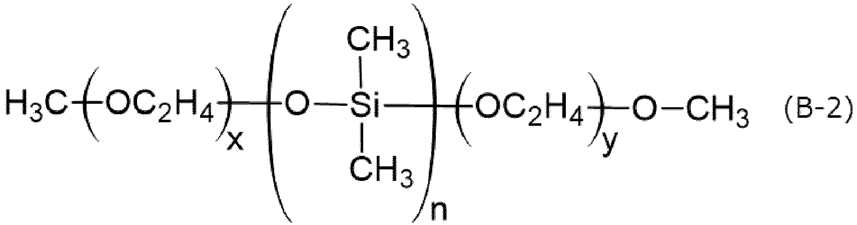
(in the formula (B-2), n, x and y each represent an integer).

4. The adhesive according to claim 3, wherein
in the formula (B-1), the group represented by R is a poly(oxyethylene) group, a poly(oxypropylene) group, or a group represented by the following formula (B-1-1) 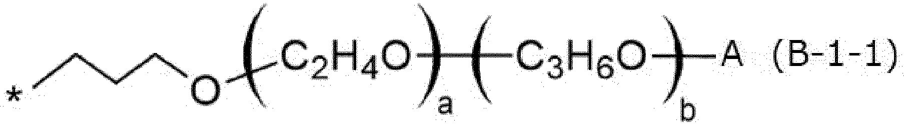
(in the formula (B-1-1), A represents H or CH₃, * represents a bond, a and b each represent an integer of 0 or more, and a + b is an integer of 1 or more).

5. The adhesive according to claim 1, wherein the processing is back surface polishing of the wafer.

6. A laminate comprising:
a first body;
a second body; and
an adhesive layer provided between the first body and the second body, wherein
the adhesive layer is formed of the adhesive according to any one of claims 1 to 5.

7. A method for producing a laminate, comprising applying the adhesive according to any one of claims 1 to 5 onto a first body to form a coating film, disposing a second body on a side of the coating film opposite to a side of the first body, and performing heating in a bonding state in which the first body and the coating film are in contact with each other and the coating film and the second body are in contact with each other, thereby forming a laminate in which the first body and the second body are bonded via an adhesive layer.

8. The method for producing a laminate according to claim 7, wherein the first body is a support, the second body is a wafer, and a circuit surface of the wafer faces the first body.

9. The method for producing a laminate according to claim 7, wherein the first body is a wafer, the second body is a support, and a circuit surface of the wafer faces the second body.

10. A method for peeling off a laminate, comprising applying the adhesive according to any one of claims 1 to 4 onto a first body to form a coating film, disposing a second body on a side of the coating film opposite to a side of the first body, and performing heating in a bonding state in which the first body and the coating film are in contact with each other and the coating film and the second body are in contact with each other, thereby forming a laminate in which the first body and the second body are bonded to each other via an adhesive layer, processing the formed laminate, and then peeling off the first body and the second body.

11. A method for peeling off a laminate, comprising applying the adhesive according to claim 5 onto a first body to form a coating film, disposing a second body on a side of the coating film opposite to a side of the first body, and performing heating in a bonding state in which the first body and the coating film are in contact with each other and the coating film and the second body are in contact with each other, thereby forming a laminate in which the first body and the second body are bonded to each other via an adhesive layer, processing the formed laminate, and then peeling off the first body and the second body.

12. The method for peeling off a laminate according to claim 10, wherein the first body is a support, the second body is a wafer, and a circuit surface of the wafer faces the first body.

13. The method for peeling off a laminate according to claim 11, wherein the first body is a support, the second body is a wafer, and a circuit surface of the wafer faces the first body.

14. The method for peeling off a laminate according to claim 10, wherein the first body is a wafer, the second body is a support, and a circuit surface of the wafer faces the second body.

15. The method for peeling off a laminate according to claim 11, wherein the first body is a wafer, the second body is a support, and a circuit surface of the wafer faces the second body.

16. The method for peeling off a laminate according to claim 10, wherein the processing is back surface polishing of the wafer.
